# EUROPEAN PATENT SPECIFICATION

(11) **EP 2 403 136 B1**
(45) Date of publication and mention of the grant of the patent: **20.06.2012**
(21) Application number: 10167761.5
(22) Date of filing: 29.06.2010
(51) Int. Cl.: H03F 1/32, H03F 3/217, H04B 14/06

(54) **Power amplifier chain implementing a sigma-delta modulator with digital predistortion feedback**
Leistungsverstärkungskette mit einem Sigma-Delta-Modulator mit digitalem Vorverzerrungsfeedback
Amplificateur de puissance mettant en oeuvre un modulateur sigma-delta doté d'un retour d'informations de prédistorsion numérique

(43) Date of publication of application: 04.01.2012
(73) Proprietor: Alcatel Lucent, 75007 Paris (FR)
(72) Inventor: Dartois, Luc, 91620 Nozay (FR)
(74) Representative: Nicolle, Olivier

(56) References cited:
- US-A1- 2006 188 027
- US-A1- 2010 104 043
- US-B1- 6 414 614
- ZRILIC D G: "Adaptive Linearization of a Power Amplifier based on Compression of Delta-Sigma Modulated Sigals" EMERGING TECHNOLOGIES: CIRCUITS AND SYSTEMS FOR 4G MOBILE WIRELESS COM MUNICATIONS, 2005. ETW '05. 2005 IEEE 7TH CAS SYMPOSIUM ON ST. PETERSBURG, RUSSIA 23-24 JUNE 2005, PISCATAWAY, NJ, USA,IEEE, 23 June 2005 (2005-06-23), pages 54-57, XP010850545 ISBN: 978-5-7422-0895-2
- THIEL B T ET AL: "System architecture of an all-digital GHz transmitter using pulse-width/position-modulation for switching-mode PAs" MICROWAVE CONFERENCE, 2009. APMC 2009. ASIA PACIFIC, IEEE, PISCATAWAY, NJ, USA, 7 December 2009 (2009-12-07), pages 2340-2343, XP031614255 ISBN: 978-1-4244-2801-4

## Description

### Field of the invention

The invention relates to a power amplifier control method implementing a sigma-delta modulator with a digital predistortion feedback.

### Background and related art

Power amplifiers used in communication systems can be identified by classes which are defined according to their operation features. For instance, power amplifiers might be classified as D class - when they mainly operate on the basis of a single transistor state - or S class - when they mainly operate on the basis of two transistors states.

In this latter case, the S class amplifier can be further classified into 1 bit or 1.5 bits depending on whether two states (only one of the two transistors drives a current in each state) or three states (two states previously indicated added to a third state whereby none of the transistors drives a current).

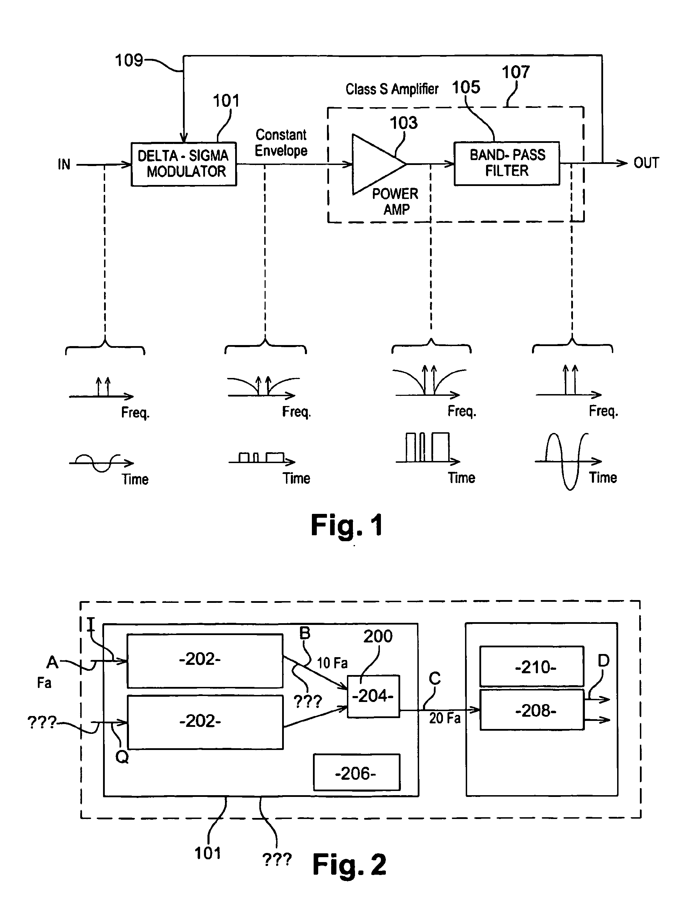

In order to feed such S or D class power amplifier with a pulsed bit stream signal, it is known to use an amplifying chain which converts a radio frequency (RF) signal IN (figure 1) into an RF pulsed signal OUT using a delta-sigma modulator 101 which outputs a pulsed bit stream signal, eventually through a Pulse Width Modulator (PWM) - not represented - when the sigma delta modulator 101 provides a multibit pulsed signal.

Thereafter the power amplifier 103, operating in a switching mode, amplifies the RF pulsed signal received from the delta-sigma modulator 101 to a required level set in the system, and outputs the amplified RF pulse signal to the band-pass filter 105.

In the example of figure 1, the delta-sigma modulator 101 converts a modulated input signal into an high speed pulse train either binary (2 states or with a small number of states or dynamic, this signal generating by nature quantization noises at an outer band of the signal.

The structure of the delta-sigma modulator 101 is represented in more detail on figure 2 as an association of sigma-delta modulation (SDM) means 202 - for instance comprising forward integrators - and a converter 204, associated to a sample RAM (random access memory) 206, which also performs signal oversampling in order to output an oversampled signal to the pulse-width-modulator (PWM) 208 associated to a clock 210.

In operation, the input signal A - with a real part I and an imaginary part Q - is treated by the SDM means 202 to be modulated into an intermediate signal B which, in this example, is oversampled by the converter/oversampler 204 by two so that the frequency of the oversampled and RF transposed signal B (called signal C) is 20Fa.

Considering, for instance, that signal A has a sampling rate Fa of 414.72MHz, it might be sampled by the delta-sigma modulation means 202 by a factor 10 so that the sampled signal B has a sampling rate of 4. 1472 GHz while the oversampling of the signal C is operated on a sampling rate of 8. 2944 GHz and is transposed to a carrier center frequency of 2.0736GHz.

Finally, it should be underlined that, in order to limit signal distortion by the operations herein above described, it is known to introduce a signal predistortion through a feedback 109 (figure 1) based on the output signal OUT in order to control the treatment of the input signal IN.

Prior art sigma-delta based power amplifiers are known from US 2010/0104043, US 2006/0188027, and US 6414614.

### The problem of the prior art:

The invention results from the finding that, in full digital transmission chains amplifiers comprising sigma-delta modulation (SDM) means, said digital predistortion feedback does not provide efficient results.

Indeed a full digital transmission chain amplifier uses both a very wide frequency band and a very high pulsed bit streams that the known feedback 109, based on the real transmitted signal OUT, cannot be performed at a satisfactory speed over the whole given band of frequency.

For instance, the digital predistortion DPD required by a full digital amplification chain in telecommunication might treat a signal with a band analysis of 100-200 MHz and a pseudo random bit stream up to 4 GHz, or even more than 8 GHz (2 to 4 times the RF carrier frequency) whereas the known digital predistortion cannot be mathematically compared and modeled at such rate and for such bandwidth, notably due to the fact that digital predistortion appears at the switching speed and cannot be analyzed when only folded effects are analyzed on a subband.

As a consequence, digital predistortion is inefficient with a gain of only 3 dB with spectral non linearities, as compared for instance with a gain of 20-25dB with Doherty amplifiers or any non switched mode power amplifiers

Thus there is a need for a power amplifier comprising sigma-delta modulation (SDM) means (102) and digital predistortion means, which performs an efficient answer at a very wideband and very high frequency used by a digital amplification chain.

### The invention:

The invention relates to power amplifier chain aimed to feed a power amplifier with a digital signal generated by sigma-delta modulation means associated with control means based on a model of the power amplifier in order to determine a control signal controlling said sigma-delta modulation means and compensate a quantification treatment of said digital signal by a quantizer, characterized in that it comprises control means to operate a feedback loop on the sigma-delta modulation means based on the signal transmitted by the sigma-delta modulations means.

Such a power amplifier chain, comprising sigma-delta modulation (SDM) means, can perform digital predistortion (DPD) dynamically in order to correct the quantification of a signal provided by SDM means directly on the basis of previously treated signal by said SDM means.

Therefore an amplifier according to the invention can perform DPD at the signal treatment frequency and over the whole band width.

In one embodiment, the power amplifier chain control means operates the feedback loop on the sigma-delta modulation means also on the basis of a signal transmitted by a Baseband to RF converter. Thus, the control means comprise means to operate the feedback loop on the basis of the signal transmitted by the Baseband to RF converter.

In one embodiment, the control means comprises a control table indicating, for each pair of a real and an imaginary signals simultaneously transmitted by the sigma-delta modulation means, a pair of real and imaginary signals to be transmitted by the sigma-delta modulations means in order to compensate the quantification of transmitted pair of signals.

In one embodiment, the control table pairs correspond to a finite number of the power amplifier operating states, so that a pair of real and imaginary signals is identified depending on said power amplifier state.

In one embodiment, the control table is a predistortion table controlling the sigma-delta modulation means in order to compensate for amplitude and phase distortion of the sigma-delta generated signal by a quantizer.

In one embodiment, the control table comprises at least two symmetric parts relating to a real and an imaginary part of the quantified signal.

The invention also relates to a power amplifier control method aimed to control the feeding of a power amplifier with a digital signal, said digital signal being generated by sigma-delta modulation means associated with control means based on a model of the power amplifier in order to determine a control signal controlling said sigma-delta modulation means and compensate a quantification treatment of said digital signal by a quantizer, characterized in that it comprises the steps of using control means to operate a feedback loop on the sigma-delta modulation means based on the signal transmitted by the sigma-delta modulations means.

In one embodiment, the method further comprises the step of using control means which operates the feedback loop on the sigma-delta modulation means also on the basis of a signal transmitted by a Baseband to RF converter.

In one embodiment, the control means comprises a control table indicating, for each pair of a real and an imaginary signals simultaneously transmitted by the sigma-delta modulations means, a pair of real and imaginary signals to be transmitted by the sigma-delta modulations means in order to compensate the quantification of transmitted pair of signals.

The invention also relates to a method for calibrating and fulfilling a control table used in a power amplifier control method according to the previous embodiment characterized in that it comprises the following steps:
- Step 1: The number of the power amplifier states is identified,
- Step 2: The delta-sigma modulation means is configured to generate a fixed and recurrent pattern of real and imaginary signals,
- Step 3: The amplitude and the phase are measured and stored in the table.

### Brief description of the drawings:

In the following description, preferred embodiments of the invention will be described, by way of example only, and with reference to the drawings in which:
- Figure 1, already described, is a schematic representation of a known power amplifier chain and the nature of the signals generating therein,
- Figure 2, already described, is a schematic view of a power amplifier comprising a converter;
- Figure 3 is a schematic view of a quantizer structure according to the invention; and
- Figure 4 represents a quantizer table which might be implemented by figure 3 quantizer, and
- Figure 5 is a diagram of the main operations performed by an amplifying chain according to the invention.

### Detailed description:

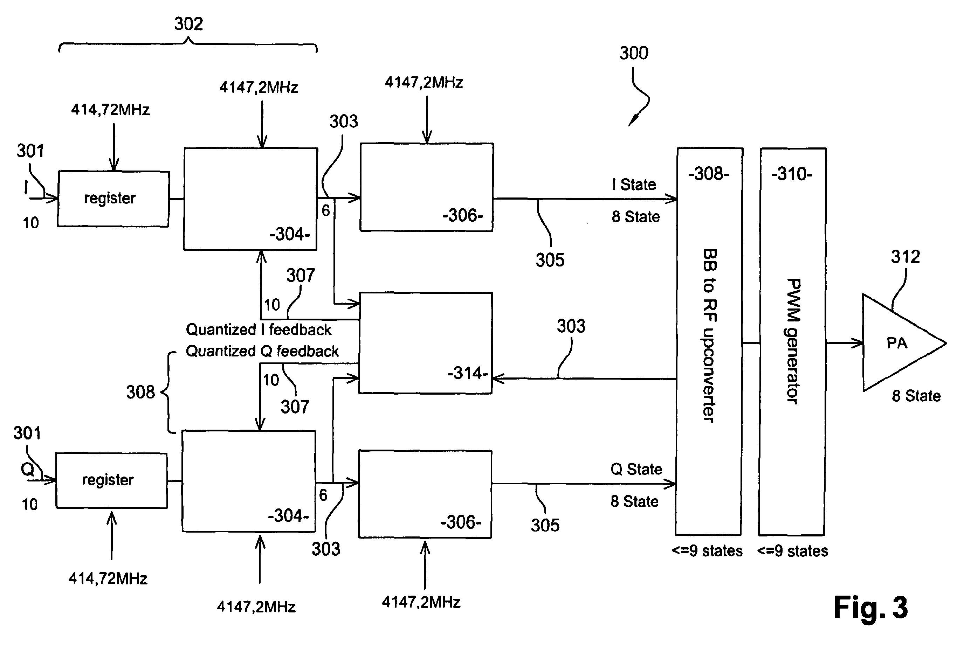

Like numbered elements in these figures are either identical elements or perform the same function. Elements which have been discussed previously will not necessarily be discussed in later figures if the function is identical.
In reference to figure 3, a power amplifier chain 300 according to the invention comprises sigma-delta modulation (SDM) means 302 which, among other elements, do comprise forward integrators 304 coding 10 bits input signals 301 - a real part I and an imaginary part Q - into a 6 bits digital signal 303 which is transmitted to both:
- A non linear quantizer means 306 which approximates the 6 bits value through a 8 states signal 305 transmitted to a baseband to RF converter 308 associated to a PWM generator (optional) and a power amplifier 312, and
- A digital predistortion (DPD) means 314 which provides the SDM means 302 with a feedback signal 307 coding a control signal to be considered by the SDM means on 10 bits.
Such control can be performed at the very high sampling rate signal 303, through a very wide band and with an accurate precision.

Indeed the DPD means use a pre-quantification signal, coded on 6 bits which provide enough information to estimate with accuracy the signal transmitted on 3 bits by the quantizer. As a matter of fact, it is estimated that 3+n bits are required to estimate the correction required by a quantification of a n bit signal without adding significant bias noise in the corresponding spectrum

Moreover, the DPD means can control the signal 303 across the entire frequency band used by the chain amplifier - above 400 Mhz - and at its very high sampling rate since the generation of the control signal 307 can rely on a simple table identifying, for a given state of the signal, the correction to be considered to the next given state of said signal.

Finally, the DPD means are updated by a signal 303' issued by the Baseband to RF converter 308 so that the control signal 307 aims to correct the SDM means on the basis of the real power amplifier functioning.

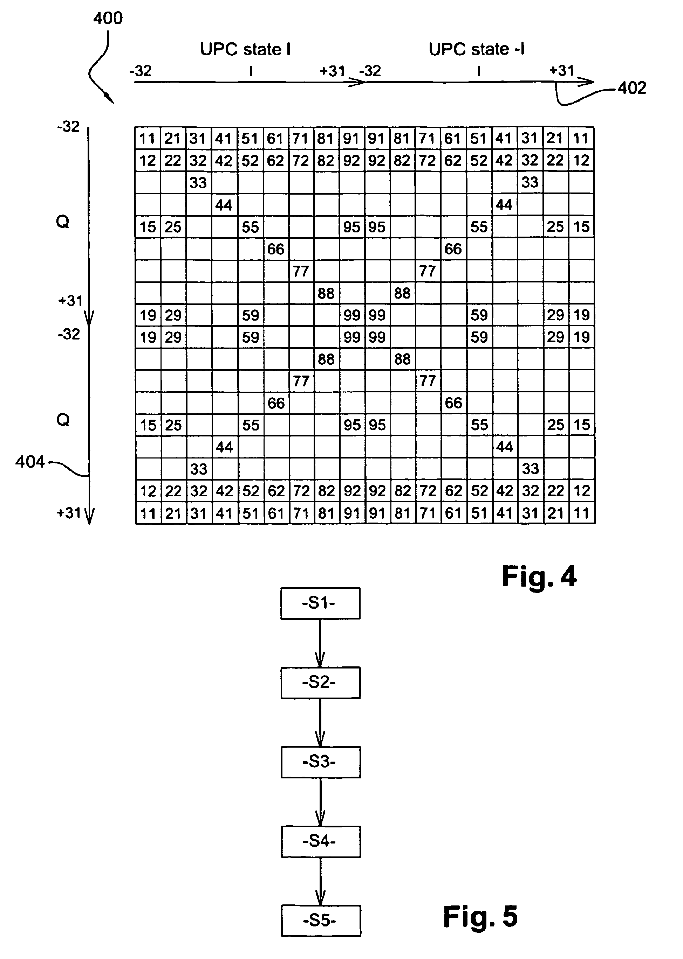

In reference to figure 4 is represented an example 400 of DPD means illustrated as a table which identify the real signal I (axis 402) and the imaginary signal Q (axis 404) according to one of their 64 possible states (6 bits coding each signal) in this embodiment of the invention.

In other words, said table 400 represents amplification behavior of the power amplifier 312, both in amplitude and in phase (AMAM and AMPM) for each I and Q state pair since the modeling of the power amplifier requires to consider simultaneously both the real I and the imaginary Q signals.

Said quantizer table 400 comprises 4 symmetric parts, two symmetric parts relating to the real part I and two symmetric parts relating to the imaginary part Q of the quantified signal, said symmetry reflecting the treatment of the signals through the Baseband to RF converter 308.

Indeed, due to a factor 4 in the upsampling rate at 8GHhz of the Baseband to RF upconverter rate at 2GHz, there are 4 RF samples per carrier period and therefore 4 states for I and Q signals sign changes, the 4 upconverter (or converter) states serving to address the table.

The reason for different values in the table for same I and Q values and different states lies in the I or Q sign which might change through the Baseband to RF converter, said change tending to compress high I and Q amplitudes which are thus less used.

Said table 400 implements a calibration of the DPD so that, for a given I and Q pair signals transmitted by the SDM means and, according to the signal is measured at the output of the considered power amplifier 312, a signal control can be transmitted to the SDM means in order to compensate the quantification operation.

A method for calibrating and fulfilling a predistorsion table might be performed for one I and Q value according to the following steps:
- Step 1: The number of the power amplifier 312 states is identified. For example 8*8=64 states.
- Step 2: The DSM means 302 output is configured to generate a fixed and recurrent pattern of signals (both I and Q) states that, through the Base Band and RF converter, generate a given state (in both amplitude and phase) at the power amplifier output.
- Step 3: Through a narrow band receiver and at transmitted frequency the gain and the phase is measured and stored in the table 500. Said measures can be precisely determined by averaging measures over a period as reduced as a few 10µs to get the appropriate accuracy according to quantization of the table.

Thereafter, synchronously - i.e. without modifying sampling rates and clocks in the overall transmission chain - another pair of I&Q states is generated so that the amplitude and phase at the output of the power amplifier is captured and stored in table 400, until all the power amplifier states are covered.

This method allows fulfilling one quadrant of the table while the 3 other quadrants are filled by symmetry as previously described.

The invention can be operated according to different embodiments. For instance, a power amplifier apparatus performing both sigma-delta modulation and pulse width modulation can implement the invention when feeding a classic class-S power amplifier. Another example can be a multibranch power amplifier fed with the 3 bit streams from the DS means whereby the 3bits samples from the delta-sigma means and the upconverter are transmitted directly to a binary weighted 3 ways amplifier that combines power from those 3 branches to give an RF signal whose instantaneous amplitude is reproducing the 3bits input words.

In this case, such apparatus performs, as described in figure 5, one or many of the following steps:
- Step S1 comprises receiving a digital signal via an input.
- Step S2 comprises modulating the digital signal by sigma-delta modulation into a modulated digital signal.
- Step S3 comprises sampling the modulated digital signal from a base bandwidth to a radio frequency bandwidth after the sigma-delta modulation.
- Step S4 (optional) comprises transforming the sampled and modulated digital signal into an analogue signal by means of a pulse width modulation.
- Step S5 comprises amplifying output of S3 or S4.

In one embodiment, a method is considered to correct some "memory effects" as part of the predistorsion models. Indeed, non linearities depend not only from instant signal applied but also depend on few previous single samples passed through the power amplifier.

In a switched mode power amplifier, this effect could be corrected if it is modeled in the delta-sigma modulator feedback, for instance by simply considering (at least one) past sample to determine the feedback predistortion value. In such case the table 400 would contain more values and will be addressed also by previous quantized values of the real I and the imaginary Q part of corresponding past sample.

## Claims

1. Power amplifier chain (302, 306, 308, 310) aimed to feed a power amplifier (312) with a digital signal (303) generated by sigma-delta modulation means (302) associated with control means (314) based on a model of the power amplifier (312) in order to determine a control signal (307) controlling said sigma-delta modulation means and compensate a quantification treatment of said digital signal (303) by a quantizer (306), **characterized in that** it comprises control means (314) to operate a feedback loop on the sigma-delta modulation means (312) based on the signal (303) transmitted by the sigma-delta modulations means.

2. Power amplifier chain according to claim 1 **characterized in that** the control means (314) operate the feedback loop on the sigma-delta modulation means (312) also on the basis of a signal (303') transmitted by a Baseband to RF converter (308).

3. Power amplifier chain according to claim 1 or 2 **characterized in that** the control means comprises a control table (400) indicating, for each pair of a real (I) and an imaginary (Q) signals simultaneously transmitted by the sigma-delta modulations means (302), a pair of real and imaginary signals to be transmitted by the sigma-delta modulations means in order to compensate the quantification of transmitted pair of signals.

4. Power amplifier chain according to claim 3 wherein the control table (400) pairs correspond to a finite number of the power amplifier operating states, so that a pair of real and imaginary signals is identified depending on said power amplifier state.

5. Power amplifier chain according to claims 2, 3 or 4 wherein the control table is a predistortion table controlling the sigma-delta modulation means (302) in order to compensate for amplitude and phase distortion of the sigma-delta generated signal by a quantizer.

6. Power amplifier chain according to claim 5 wherein the control table comprises at least two symmetric parts relating to a real and an imaginary part of the quantified signal.

7. Power amplifier control method aimed to control the feeding of a power amplifier (312) with a digital signal (303), said digital signal (303) being generated by sigma-delta modulation means (102) associated with control means (314) based on a model of the power amplifier (312) in order to determine a control signal (307) controlling said sigma-delta modulation means and compensate a quantification treatment of said digital signal (303) by a quantizer (306), **characterized in that** it comprises the steps of using control means (314) to operate a feedback loop on the sigma-delta modulation means (312) based on the signal (303) transmitted by the sigma-delta modulations means.

8. Power amplifier control method according to claim 7 **characterized in that** it comprises the step of using control means (314) which operates the feedback loop on the sigma-delta modulation means (312) also on the basis of a signal (303') transmitted by a Baseband to RF converter (308).

9. Power amplifier control method according to claim 7 or 8 **characterized in that** the control means comprises a control table (400) indicating, for each pair of a real (I) and an imaginary (Q) signals simultaneously transmitted by the sigma-delta modulations means (302), a pair of real and imaginary signals to be transmitted by the sigma-delta modulations means in order to compensate the quantification of transmitted pair of signals.

10. Method for calibrating and fulfilling a control table (400) used in a power amplifier control method according to the claim 9 **characterized in that** it comprises the following steps:
- Step 1: The number of the power amplifier (312) states is identified,
- Step 2: The delta-sigma modulation means (302) is configured to generate a fixed and recurrent pattern of real and imaginary signals,
- Step 3: The amplitude and the phase are measured and stored in the table (400).

## Patentansprüche

1. Leistungsverstärkerkette (302, 306, 308, 310), dazu bestimmt, einen Leistungsverstärker (312) mit einem von mit Steuermitteln (314) assoziierten Sigma-Delta-Modulationsmitteln auf der Basis eines Modells des Leistungsverstärkers (312) erzeugten digitalen Signal (303) zu versorgen, um ein Steuersignal (307), welches die besagten Sigma-Delta-Modulationsmittel steuern, zu ermitteln und eine Quantisierungsbearbeitung des besagten digitalen Signals (303) durch einen Quantisierer (306) zu kompensieren, **dadurch gekennzeichnet, dass** sie Steuermittel (314) für den Betrieb einer Rückkopplungsschleife auf den Sigma-Delta-Modulationsmitteln (312) auf der Basis des von den Sigma-Delta-Modulationsmitteln übertragenen Signals (303) umfasst.

2. Leistungsverstärkerkette nach Anspruch 1, **dadurch gekennzeichnet, dass** die Steuermittel (314) die Rückkopplungsschleife auf den Sigma-Delta-Modulationsmitteln (312) ebenfalls auf der Basis eines von einem Basisband-zu-HF-Umsetzer (308) übertragenen Signals (303') betreiben.

3. Leistungsverstärkerkette nach Anspruch 1 oder 2, **dadurch gekennzeichnet, dass** das Steuermittel eine Steuerungstabelle (400) umfasst, welche für jedes gleichzeitig von den Sigma-Delta-Modulationsmitteln (302) übertragenes Paar eines reellen (I) und eines imaginären (Q) Signals ein von den Sigma-Delta-Modulationsmitteln zu übertragenes Paar von reellen und imaginären Signalen anzeigt, um die Quantisierung von übertragenen Signalpaaren zu kompensieren.

4. Leistungsverstärkerkette nach Anspruch 3, wobei die Paare in der Steuerungstabelle (400) einer endlichen Anzahl von Betriebszuständen des Leistungsverstärkers entsprechen, sodass ein Paar von reellen und imaginären Signalen in Abhängigkeit von dem Zustand des besagten Leistungsverstärkers identifiziert wird.

5. Leistungsverstärkerkette nach den Ansprüchen 2, 3 oder 4, wobei die Steuerungstabelle eine Vorverzerrungstabelle ist, welche die Sigma-Delta-Modulationsmittel (302) steuert, um die Amplituden- und Phasenverzerrung des von Sigma-Delta erzeugten Signals durch einen Quantisierer zu kompensieren.

6. Leistungsverstärkerkette nach Anspruch 5, wobei die Steuerungstabelle mindestens zwei symmetrische Teile in Bezug auf einen reellen und einen imaginären Teil des quantisierten Signals enthält.

7. Verfahren zur Steuerung eines Leistungsverstärkers, dazu bestimmt, die Versorgung eines Leistungsverstärkers (312) mit einem digitalen Signal (303) zu steuern, wobei das besagte digitale Signals (303) von mit Steuerungsmitteln (314) assoziierten Sigma-Delta-Modulationsmittein (102) auf der Basis eines Modelles des Leistungsverstärkers (312) erzeugt werden, um ein Steuersignal (307), welches die besagten Sigma-Delta-Modulationsmittel steuert, zu ermitteln und eine Quantisierungsbearbeitung des besagten digitalen Signals (303) durch einen Quantisierer (306) zu kompensieren, **dadurch gekennzeichnet, dass** es die Schritte des Verwendens von Steuermitteln (314) für das Betreiben einer Rückkopplungsschleife auf den Sigma-Delta-Modulationsmitteln (312) auf der Basis des von den Sigma-Delta-Modulationsmitteln übertragenen Signals (303) umfasst.

8. Verfahren zur Steuerung eines Leistungsverstärkers nach Anspruch 7, **dadurch gekennzeichnet, dass** es den Schritt des Verwendens eines Steuermittels (314), welche die Rückkopplungsschleife auf den Sigma-Delta-Modulationsmitteln (312) ebenfalls auf der Basis eines von einem Basisband-zu-HF-Umsetzer (308) übertragenen Signals (303') betreibt, umfasst.

9. Verfahren zur Steuerung eines Leistungsverstärkers nach Anspruch 7 oder 8, **dadurch gekennzeichnet, dass** das Steuermittel eine Steuerungstabelle (400) umfasst, welche für jedes gleichzeitig von den Sigma-Delta-Modulationsmitteln (302) übertragenes Paar eines reellen (I) und eines imaginären (Q) Signals ein durch die Sigma-Delta-Modulationsmittel zu übertragendes Paar von reellen und imaginären Signalen anzeigt, um die Quantisierung des übertragenen Signalpaars zu kompensieren.

10. Verfahren zum Kalibrieren und Erfüllen einer in einem Verfahren zur Steuerung eines Leistungsverstärkers gemäß Anspruch 9 verwendeten Steuerungstabelle (400), **dadurch gekennzeichnet, dass** es die folgenden Schritte umfasst:
- Schritt 1: Die Anzahl der Zustände des Leistungsverstärkers (312) wird identifiziert,
- Schritt 2: Das Sigma-Delta-Modulationsmittel (302) wird konfiguriert, um ein festgesetztes und wiederkehrendes Muster von reellen und imaginären Signalen zu erzeugen,
- Schritt 3: Die Amplitude und die Phase werden gemessen und in der Tabelle (400) gespeichert.

## Revendications

1. Chaîne d'amplificateur de puissance (302, 306, 308, 310) destinée à alimenter un amplificateur de puissance (312) avec un signal numérique (303) généré par des moyens de modulation sigma-delta (302) associés à des moyens de commande (314) en se basant sur un modèle de l'amplificateur de puissance (312) afin de déterminer un signal de commande (307) commandant lesdits moyens de modulation sigma-delta et de compenser un traitement de quantification dudit signal numérique (303) au moyen d'un quantificateur (306), **caractérisée en ce qu'**elle comprend des moyens de commande (314) pour réaliser une boucle de rétroaction sur les moyens de modulation sîgma-delta (312) en se basant sur le signal (303) transmis par les moyens de modulation sigma-delta.

2. Chaîne d'amplificateur de puissance selon la revendication 1, **caractérisée en ce que** les moyens de commande (314) réalisent la boucle de rétroaction sur les moyens de modulation sigma-delta (312) en se basant également sur un signal (303') transmis par un convertisseur bande de base/RF (308).

3. Chaîne d'amplificateur de puissance selon la revendication 1 ou 2, **caractérisée en ce que** les moyens de commande comprennent une table de commande (400) indiquant, pour chaque paire d'un signal réel (I) et d'un signal imaginaire (Q) transmis simultanément par les moyens de modulation sigma-delta (302), une paire de signaux réel et imaginaire devant être transmise par les moyens de modulation sigma-delta afin de compenser la quantification de la paire de signaux transmise.

4. Chaîne d'amplificateur de puissance selon la revendication 3, dans laquelle les paires de la table de commande (400) correspondent à un nombre fini des états de fonctionnement de l'amplificateur de puissance, de sorte qu'une paire de signaux réel et imaginaire soit identifiée en fonction dudit état de l'amplificateur de puissance.

5. Chaîne d'amplificateur de puissance selon la revendication 2, 3 ou 4, dans laquelle la table de commande est une table de prédistorsion commandant les moyens de modulation sigma-delta (302) afin de compenser l'amplitude et la distorsion de phase du signal généré par les moyens de modulation sigma-delta au moyen d'un quantificateur.

6. Chaîne d'amplificateur de puissance selon la revendication 5, dans laquelle la table de commande comprend au moins deux parties symétriques associées à une partie réelle et à une partie imaginaire du signal quantifié.

7. Procédé de commande d'amplificateur de puissance destiné à commander l'alimentation d'un amplificateur de puissance (312) avec un signal numérique (303), ledit signal numérique (303) étant généré par les moyens de modulation sigma-delta (102) associés aux moyens de commande (314) en se basant sur un modèle de l'amplificateur de puissance (312) afin de déterminer un signal de commande (307) commandant lesdits moyens de modulation sigma-delta et de compenser un traitement de quantification dudit signal numérique (303) au moyen d'un quantificateur (306), **caractérisé en ce qu'**il comprend les étapes d'utilisation des moyens de commande (314) pour réaliser une boucle de rétroaction sur les moyens de modulation sigma-delta (312) en se basant sur le signal (303) transmis par les moyens de modulation sigma-delta.

8. Procédé de commande d'amplificateur de puissance selon la revendication 7, **caractérisé en ce qu'**il comprend l'étape d'utilisation des moyens de commande (314) qui réalisent la boucle de rétroaction sur les moyens de modulation sigma-detta (312) en se basant également sur un signal (303') transmis par un convertisseur bande de base/RF (308).

9. Procédé de commande d'amplificateur de puissance selon la revendication 7 ou 8, **caractérisé en ce que** les moyens de commande comprennent une table de commande (400) indiquant, pour chaque paire d'un signal réel (I) et d'un signal imaginaire (Q) transmis simultanément par les moyens de modulation sigma-delta (302), une paire de signaux réel et imaginaire devant être transmise par les moyens de modulation sigma-delta afin de compenser la quantification de la paire de signaux transmise.

10. Procédé pour étalonner et remplir une table de commande (400) utilisée dans un procédé de commande d'amplificateur de puissance selon la revendication 9, **caractérisé en ce qu'**il comprend les étapes suivantes :
- Étape 1 : le nombre des états de l'amplificateur de puissance (312) est identifié,
- Étape 2 : les moyens de modulation delta-sîgma (302) sont configurés pour générer un modèle fixe et récurrent de signaux réel et imaginaire,
- Étape 3 : l'amplitude et la phase sont mesurées et stockées dans la table (400).
